# EUROPEAN PATENT APPLICATION

(11) **EP 4 585 950 A2**
(43) Date of publication of application: **16.07.2025**
(21) Application number: 25150932.9
(22) Date of filing: 09.01.2025
(51) Int. Cl.: G01R 33/00, G01R 33/12

(54) **MAGNETIC FIELD DETECTION SYSTEM**

(30) Priority: 12.01.2024 JP 2024003035
(71) Applicant: TDK Corporation, Tokyo 103-6128 (JP)
(72) Inventor: YAMAJI, Yuichiro, Tokyo, 103-6128 (JP)
(74) Representative: Epping - Hermann - Fischer

(57) **Abstract**

Disclosed herein is a magnetic field detection system that includes a shield box having a magnetic shield surrounding a measurement space, a magnetic sensor provided in the measurement space and fixed to the shield box, a sample stage at least a part of which is inserted into the measurement space, a table fixed to the sample stage and on which a sample is placed, and a drive mechanism configured to change a position of the sample stage. The table has a protruding part protruding from the sample stage without overlapping the sample stage. At least the protruding part of the table is constituted by a material positioned at a more positive side in a triboelectric series than a material constituting the sample stage.

## Description

### BACKGROUND OF THE ART

### --Field of the Art

The present disclosure relates to a magnetic field detection system and, more particularly, to a magnetic field detection system capable of serving as a foreign object detection system.

### --Description of Related Art

International Publication WO 2023/204135 discloses a magnetic field detection system provided with a drive mechanism for changing the relative positional relationship between a shield box to which a magnetic sensor is fixed and a sample stage. Further, JP 2014-224811A discloses a device that uses a static electricity eliminator to eliminate static electricity with which an object to be inspected is charged before carrying the object to be inspected in a magnetic shield box having therein a magnetic sensor.

In the system described in International Publication WO 2023/204135, the sample stage itself may be electrostatically charged due to friction with air caused by the movement thereof. When the sample stage is electrostatically charged, a magnetic field generated by static electricity becomes noise, disadvantageously deteriorating detection sensitivity. Such static electricity can be eliminated using the static electricity eliminator described in JP 2014-224811A; however, friction between the sample stage and air is generated constantly during measurement, so that only eliminating static electricity before carrying the sample stage in the shield box may be insufficient.

### SUMMARY

The present disclosure describes a technology for preventing deterioration in detection sensitivity caused by static electricity in a magnetic field detection system capable of serving as a foreign object detection system.

A magnetic field detection system according to an embodiment of the present disclosure includes: a shield box having a magnetic shield surrounding a measurement space; a magnetic sensor provided in the measurement space and fixed to the shield box; a sample stage at least a part of which is inserted into the measurement space; a table fixed to the sample stage and on which a sample is placed; and a drive mechanism for changing the position of the sample stage, wherein the table has a protruding part protruding from the sample stage without overlapping the same, and at least the protruding part of the table is constituted by a material positioned at the more positive side in a triboelectric series than a material constituting the sample stage.

A magnetic field detection system according to another embodiment of the present disclosure includes: a shield box having a magnetic shield surrounding a measurement space; a magnetic sensor provided in the measurement space and fixed to the shield box; a sample stage at least a part of which is inserted into the measurement space; a table fixed to the sample stage and on which a sample is placed; and a drive mechanism for changing the position of the sample stage, wherein both the sample stage and table are constituted by a material having a work function of 4 eV or less.

According to this disclosure, it can be obtained that a technology for preventing deterioration in detection sensitivity caused by static electricity in a magnetic field detection system capable of serving as a foreign object detection system.

### BRIEF DESCRIPTION OF THE DRAWINGS

The above features and advantages of the present disclosure will be more apparent from the following description of some embodiments taken in conjunction with the accompanying drawings, in which:
FIG. 1 is a schematic perspective view illustrating the outer appearance of a magnetic field detection system 100 according to an embodiment of the present invention;
FIGS. 2 and 3 are schematic perspective views for explaining the structure of the shield box 200 as viewed from mutually different directions;
FIG. 4 is a schematic perspective view for explaining the structure of the sample stage 300;
FIG. 5 is a schematic perspective view showing a state in which the sample stage 300 is inserted into the measurement space 230;
FIG. 6 is a triboelectric series table;
FIG. 7 is a schematic perspective view for explaining the structure of the sensor holder 400;
FIG. 8 is a schematic perspective view for explaining the structure of the sensor main body part 10;
FIG. 9 is a schematic exploded perspective view for explaining the structure of the sensor main body part 10;
FIG. 10 is a schematic perspective view illustrating a state where the magnetic yokes M1 to M3 are removed from the magnetic sensor 40;
FIG. 11 is a schematic diagram for explaining a method of scanning the sample 320 with the sensor body 10;
FIG. 12 is a schematic diagram for explaining the magnetic field generated by the metallic foreign object 321;
FIG. 13 is a graph illustrating the relationship between the length of the protruding part 311 of the table 310 and sensor output when no sample 320 is present;
FIG. 14 is a schematic perspective view for explaining the structure of a sample stage 300 having a holding part 303;
FIG. 15 is a schematic perspective view for explaining a first modification; and
FIG. 16 is a schematic perspective view for explaining a second modification.

### DETAILED DESCRIPTION OF THE EMBODIMENTS

Some embodiments of the present disclosure will be explained below in detail with reference to the accompanying drawings.

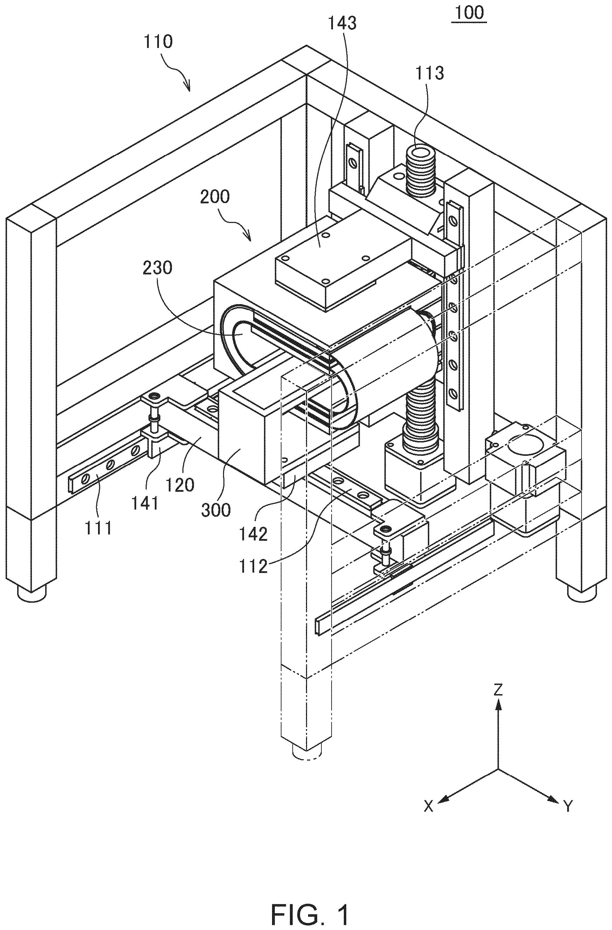

FIG. 1 is a schematic perspective view illustrating the outer appearance of a magnetic field detection system 100 according to an embodiment of the present invention.

As illustrated in FIG. 1, the magnetic field detection system 100 according to the present embodiment has a frame 110, a shield box 200, and a sample stage 300. The shield box 200 and sample stage 300 are supported by the frame 110. The frame 110 has a guide 111 extending in the X-direction, a guide 113 extending in the Z-direction, and a movable beam 120 configured to be movable in the X-direction along the guide 111. The shield box 200 is connected to the guide 113, and the sample stage 300 is connected to the movable beam 120.

The movable beam 120 is movably configured in the X-direction by a drive mechanism 141 (e.g., a motor) . The movable beam 120 is provided with a guide 112 extending in the Y-direction, and the sample stage 300 is movably configured in the Y-direction along the guide 112. The Y-direction movement of the sample stage 300 along the guide 112 is achieved by a drive mechanism 142 (e.g., a motor). The shield box 200 is movably configured in the Z-direction along the guide 113. The Z-direction movement of the shield box 200 along the guide 113 is achieved by a drive mechanism (e.g., a motor). Thus, the relative positional relationship between the shield box 200 and sample stage 300 can be varied by the drive mechanisms 141 to 143.

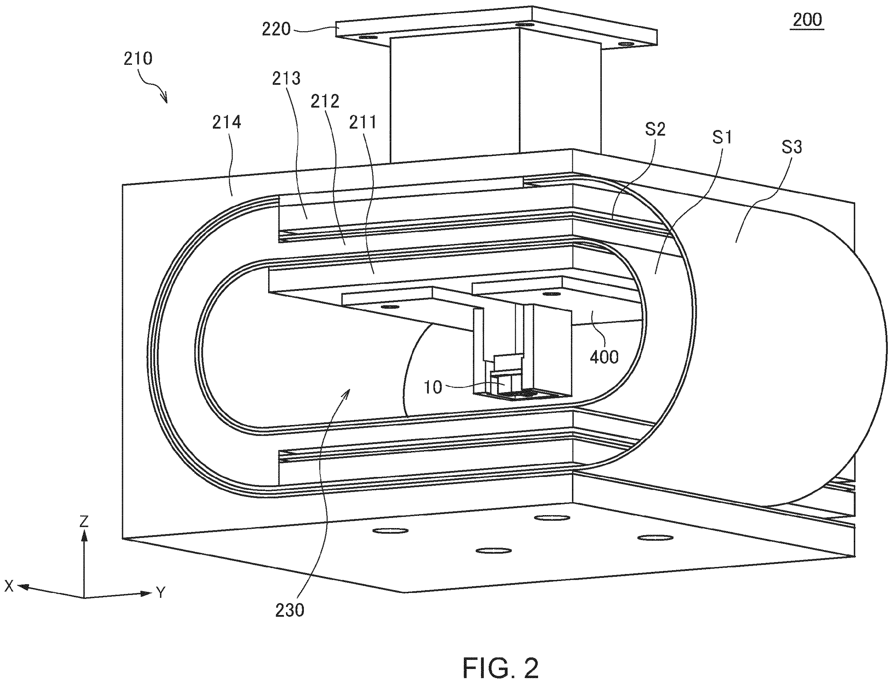

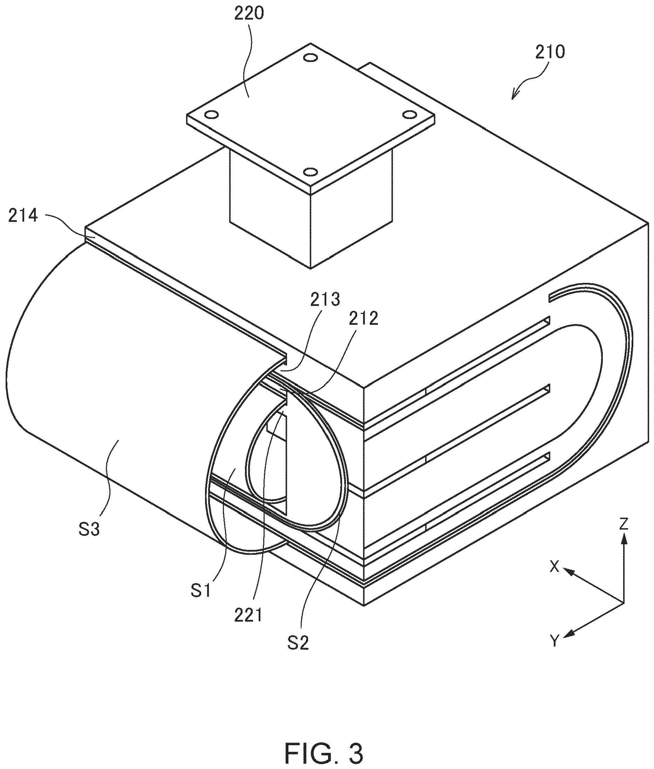

FIGS. 2 and 3 are schematic perspective views for explaining the structure of the shield box 200 as viewed from mutually different directions.

As illustrated in FIGS. 2 and 3, the shield box 200 has a main body part 210 made of resin or the like and a connection part 220 connecting the main body part 210 to the guide 113. The main body part 210 is provided with magnetic shields S1 to S3 each made of a high permeability material such as permalloy. The magnetic shields S1 to S3 are arranged so as to surround a measurement space 230. Among them, the magnetic shield S1 is positioned at the innermost side, and the magnetic shield S3 is positioned at the outermost side. The main body part 210 includes a plurality of parts 211 to 214. The part 211 is positioned at the inner wall side of the magnetic shield S1, part 212 is positioned between the magnetic shields S1 and S2, part 213 is positioned between the magnetic shields S2 and S3, and part 214 is positioned at the outer wall side of the magnetic shield S3. The part 211 is fixed with a sensor holder 400 holding a sensor main body part 10, whereby the sensor main body part 10 is fixed to the shield box 200 in the measurement space 230.

The magnetic shield S1 is a cylindrical body covering the measurement space 230 from both sides in the Y-direction and both sides in the Z-direction and has a pair of flat parts constituting the XY plane and curved parts each connecting, in an arc, the pair of flat parts. The part 211 of the main body part 210 covers the inner wall of one flat part of the magnetic shield S1. The magnetic shield S2 is a plate-like body positioned outside the magnetic shield S1 and curved in a C-shape so as to cover the measurement space 230 from one side in the X-direction and both sides in the Z-direction. The magnetic shield S3 is a plate-like body positioned outside the magnetic shield S2 and curved in a C-shape so as to cover the measurement space 230 from both sides in the Y-direction and one side in the Z-direction. Like the magnetic shield S1, the magnetic shield S3 may be a cylindrical body covering the measurement space 230 from both sides in the Y-direction and both sides in the Z-direction.

Thus, the measurement space 230 is doubly or triply shielded in the Y- and Z-directions by the magnetic shields S1 to S3 and shielded in the X-direction by the magnetic shield S2. The other side of the measurement space 230 in the X-direction is opened, from which a part of the sample stage 300 is inserted into the measurement space 230.

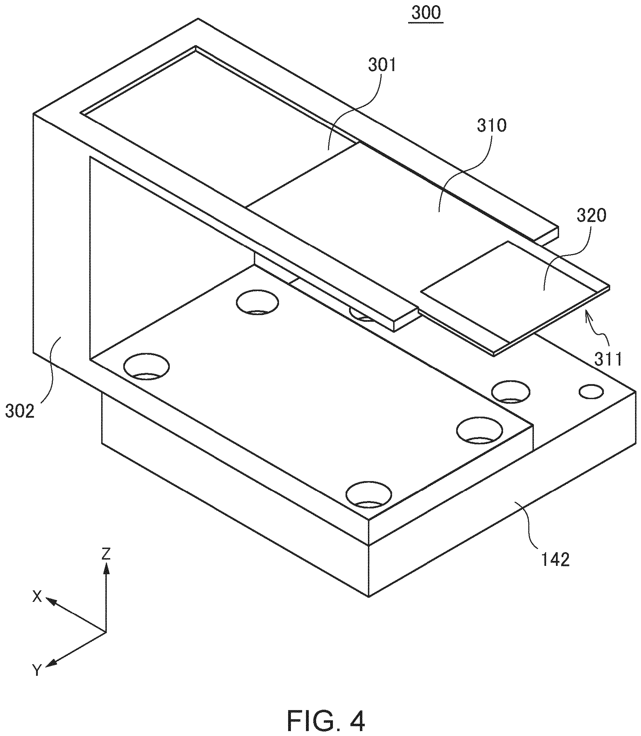

FIG. 4 is a schematic perspective view for explaining the structure of the sample stage 300.

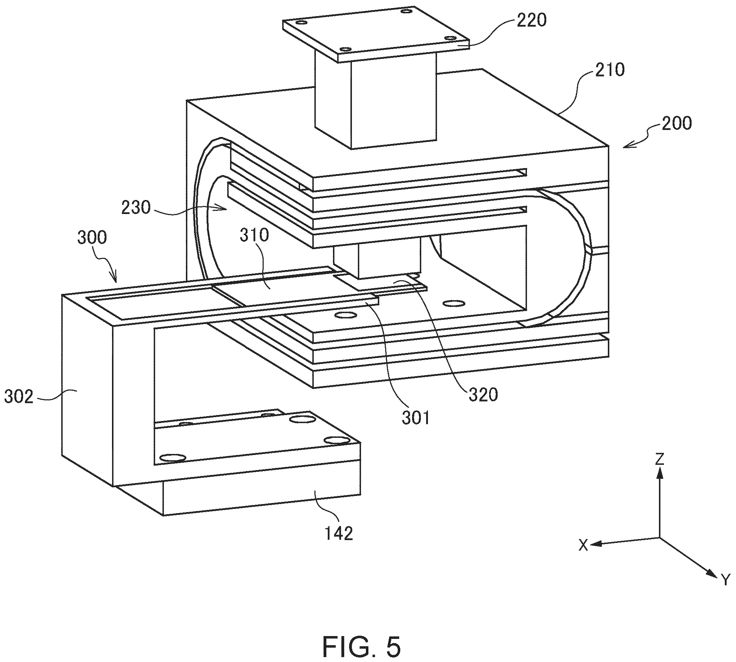

As illustrated in FIG. 4, the sample stage 300 has a mounting part 301 and a connection part 302 connecting the mounting part 301 and drive mechanism 142. The mounting part 301 is a part on which a table 310 is placed. The table 310 is a part on which a sample 320 to be inspected is place. The table 310 has a protruding part 311 protruding from the mounting part 301 of the sample stage 300 without overlapping the mounting part 301, and the sample 320 is placed on the protruding part 311. In the example illustrated in FIG. 4, the table 310 has a flat plate shape, and the surface thereof constitutes the XY plane. At the time of measurement, the mounting part 301 and table 310 are inserted into the measurement space 230 as illustrated in FIG. 5.

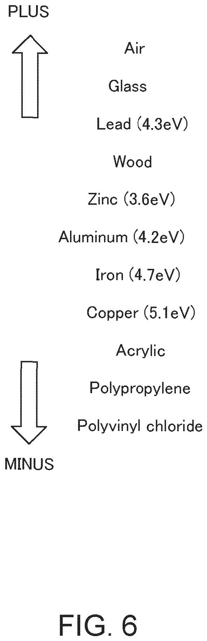

The table 310 is constituted by a material positioned at the more positive side than a material constituting the sample stage 300 in the triboelectric series. The triboelectric series is a list of substances ranked according to their tendency to be charged positive and to be charged negative (see FIG. 6). For example, an easily moldable resin material such as polyvinyl chloride can be used for the sample stage 300, and glass positioned at the more positive side than the polyvinyl chloride in the triboelectric series can be used for the table 310.

When a material positioned at the more positive side than a material constituting the sample stage 300 in the triboelectric series is used for the table 310, the table 310 itself is unlikely to be electrostatically charged even when static electricity is generated due to friction with air caused by the movement of the sample stage 300 and table 310 in the measurement space 230. That is, a material such as glass positioned at the positive side is close to air in the triboelectric series, so that there is substantially no static electricity generated due to friction with air. Therefore, even in a situation where the sample stage 300 itself is electrostatically charged, placing the sample 320 on the protruding part 311 of the table 310 can prevent deterioration in detection sensitivity.

The sequence in the triboelectric series is mostly determined based on a work function with certain exceptions such as lead. That is, a substance having a smaller function is positioned at the more positive side in the triboelectric series, and a substance having a larger function is positioned at the more negative side in the triboelectric series. With attention paid on this respect, a material having a work function of 4 eV or less is preferably used for the table 310. As the material of the table 310, a material positioned closer to air in the triboelectric series is preferably used. A material having a work function of 4 eV or less has a small difference from air in the triboelectric series, so that it is possible to suppress generation of static electricity due to friction with air. Specifically, when a material positioned at the more positive side than aluminum in the triboelectric series is used for table 310, generation of static electricity due to friction with air can be suppressed.

The table 310 need not be entirely constituted by a material positioned at the more positive side in the triboelectric series than a material constituting the sample stage 300, but a part thereof on which the sample 320 is placed, i.e., only the protruding part 311 may be constituted by the above material.

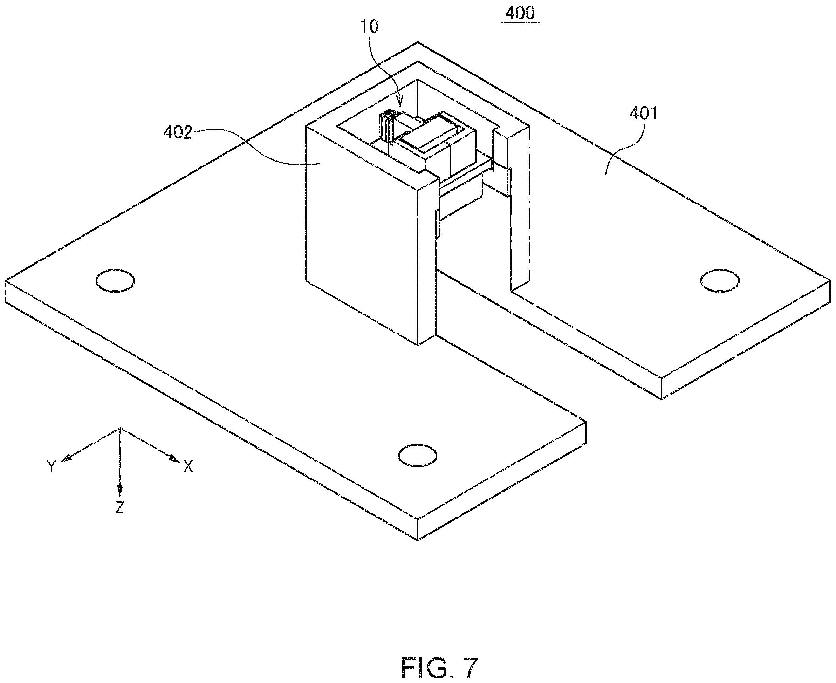

FIG. 7 is a schematic perspective view for explaining the structure of the sensor holder 400.

The sensor holder 400 is a molding made of resin or the like and has, as illustrated in FIG. 7, a plate part 401 constituting the XY plane and a sensor housing part 402 protruding in the Z-direction from the plate part 401. The XY plane of the plate part 401 is fixed to the XY plane of the part 211 of the shield box 200. The sensor housing part 402 holds the sensor main body part 10 including a magnetic sensor.

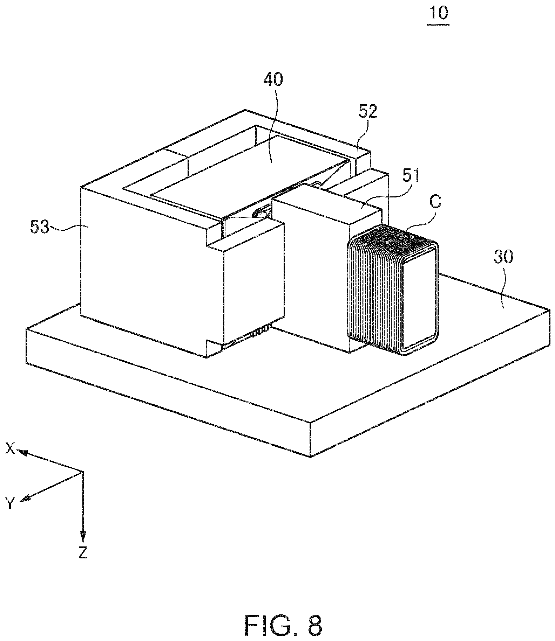

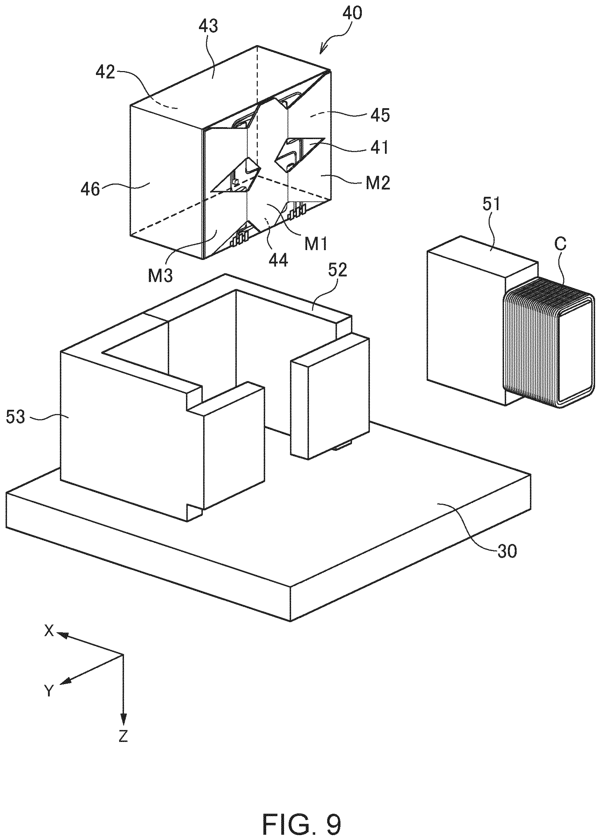

FIGS. 8 and 9 are views for explaining the structure of the sensor main body part 10. FIG. 8 is a schematic perspective view, and FIG. 9 is a schematic exploded perspective view.

As illustrated in FIGS. 8 and 9, the sensor main body part 10 has, on the surface of a sensor substrate 30, a chip-like magnetic sensor 40 and magnetic field collecting bodies 51 to 53. The magnetic sensor 40 is formed into a substantially rectangular parallelepiped shape and has an element formation surface 41 and a back surface 42 which constitute the YZ plane, upper and lower surfaces 43 and 44 which constitute the XY plane, and side surfaces 45 and 46 which constitute the XZ plane. The element formation surface 41 is a surface on which a magnetosensitive element is formed. The magnetic sensor 40 is mounted on the sensor substrate 30 such that the lower surface 44 faces the sensor substrate 30 and that the element formation surface 41 is perpendicular to the surface of the sensor substrate 30. There are formed, on the element formation surface 41 of the magnetic sensor 40, magnetic yokes M1 to M3 made of permalloy or the like, and the magnetosensitive element is disposed near magnetic gaps formed between the magnetic yoke M1 and magnetic yokes M2, M3. With this configuration, magnetic flux passing through the magnetic gap is applied to the magnetosensitive element.

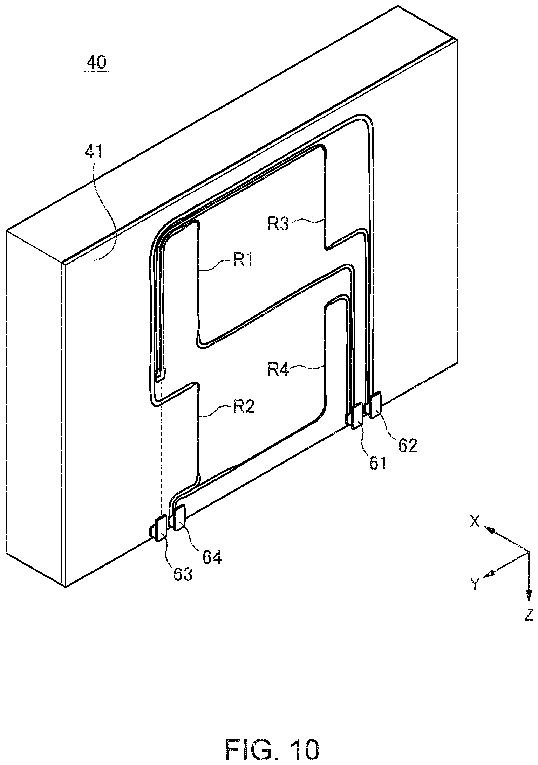

FIG. 10 is a schematic perspective view illustrating a state where the magnetic yokes M1 to M3 are removed from the magnetic sensor 40.

As illustrated in FIG. 10, magnetosensitive elements R1 to R4 are formed on the element formation surface 41 of the magnetic sensor 40. The magnetosensitive elements R1 to R4 have their magnetosensitive direction in the Y-direction. All the magnetosensitive elements R1 to R4 have magnetosensitive direction in the Y-direction. The magnetosensitive elements R1 and R2 are disposed near the magnetic gap formed between the magnetic yokes M1 and M2, and magnetosensitive elements R1 and R2 are disposed near the magnetic gap formed between the magnetic yokes M1 and M3. The magnetosensitive elements R1 to R4 are bridge-connected between terminal electrodes 61 and 62, and differential signals corresponding to a magnetic field appear at terminal electrodes 63 and 64.

The magnetic field collecting bodies 51 to 53 are blocks made of a magnetic material such as ferrite and act to collect a magnetic field emitted from the sample 320 in the magnetic sensor 40. The magnetic field collecting bodies 51 to 53 respectively overlap the magnetic yokes M1 to M3 in the X-direction. That is, the magnetic field collecting bodies 51 to 53 are arranged in the Y-direction on the element formation surface 41, the magnetosensitive elements R3 and R4 are disposed between the magnetic field collecting bodies 51 and 52 as viewed in the X-direction, and the magnetosensitive elements R1 and R2 are disposed between the magnetic field collecting bodies 51 and 53 as viewed in the X-direction.

The magnetic field collecting body 51 is elongated in the X-direction and acts to collect mainly a magnetic field in the X-direction in the magnetic yoke M1. The magnetic field collecting body 52 covers the side and back surfaces 45 and 42 of the magnetic sensor 40, and magnetic field collecting body 53 covers the side and back surfaces 46 and 42 of the magnetic sensor 40. With this configuration, the X-direction magnetic field collected by the magnetic field collecting body 51 is curved by the magnetic yoke M1 to flow to the magnetic field collecting bodies 52 and 53 through the magnetic yokes M2 and M3. As a result, the magnetic field passing through the magnetic gaps between the magnetic yoke M1 and magnetic yokes M2, M3 is detected by the magnetosensitive elements R1 to R4. In the example illustrated in FIGS. 8 and 9, a compensation coil C is wound around the magnetic field collecting body 51, in which a cancellation current flows to cancel the magnetic field to be applied to the magnetosensitive elements R1 to R4.

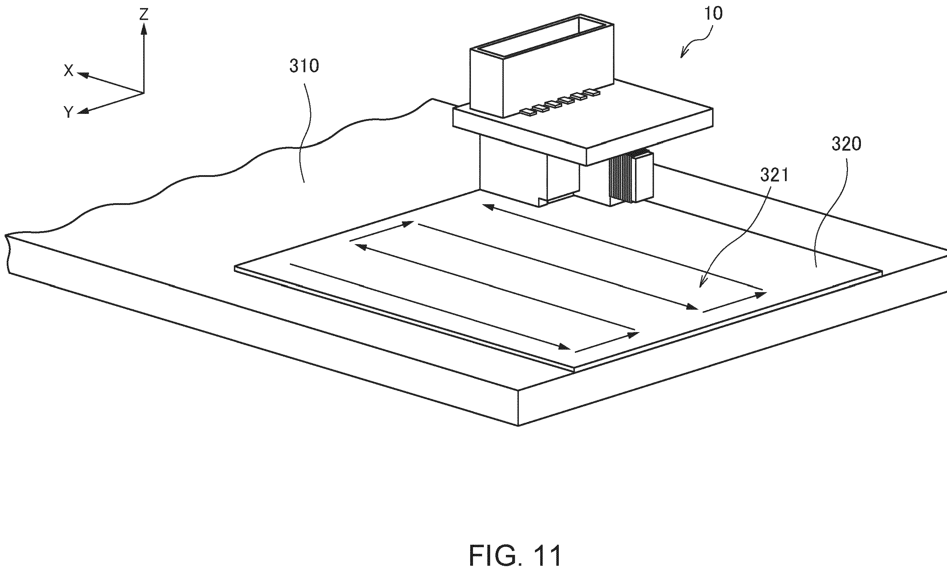

It is possible to bring the thus configured sensor main body part 10 close to the sample 320 placed on the surface of the table 310 by moving the whole shield box 200 in the Z-direction using the drive mechanism 143. The sample 320 and sensor main body part 10 in the Z-direction is preferably as close as possible within a range where they do not interfere with each other. After adjustment of the position of the sensor main body part 10 in the Z-direction by the use of the drive mechanism 143, the sample stage 300 is shifted in the XY plane direction using the drive mechanisms 141 and 142 to allow the sensor main body part 10 to scan the sample 320, as illustrated in FIG. 11. The sample 320 is applied with a magnetic field ahead of time and thus, when a metal foreign object 321 such as iron (Fe) is mixed in the sample 320, it is possible to detect a magnetic field generated by the magnetized metal foreign object 321.

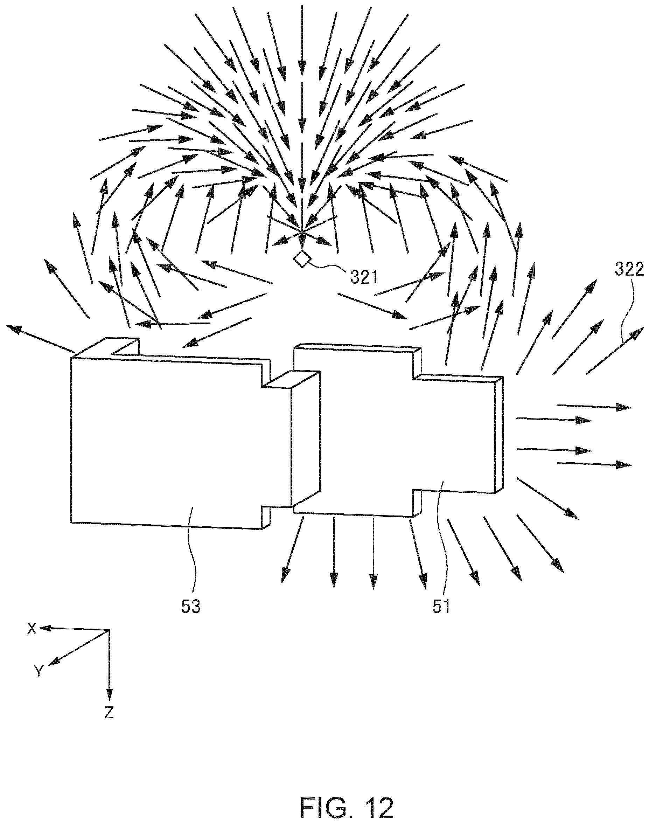

The metal foreign object 321 and sensor main body part 10 face each other in the Z-direction; however, when the sample 320 and sensor main body part 10 are brought close to each other sufficiently in the Z-direction, it is possible to collect the X-direction component of the magnetic field generated by the metal foreign object 321 using the magnetic field collecting bodies 51 to 53 and thus to apply it to the magnetosensitive elements R1 to R4, as illustrated in FIG. 12 which is a schematic view for explaining the magnetic field generated by the metal foreign object 321. In FIG. 12, a reference number 322 indicates the direction and strength of magnetic field generated by the metal foreign object 321. By thus setting the longitudinal direction (X-direction) of the magnetic field collecting body 51 perpendicular to the separating direction (Z-direction) between the sample 320 and the sensor main body part 10, it is possible to further reduce the distance between the sample 320 and the magnetosensitive elements R1 to R4 and to thereby achieve higher detection sensitivity.

As described above, in the magnetic field detection system 100 according to the present embodiment, the table 310 is constituted by a material positioned at the more positive side in the triboelectric series than a material constituting the sample stage 300, so that static electricity due to friction between the table 310 and air is unlikely to be generated when the magnetic sensor 40 scans the surface of the sample 320 in the XY plane direction. This can suppress deterioration in detection sensitivity due to static electricity.

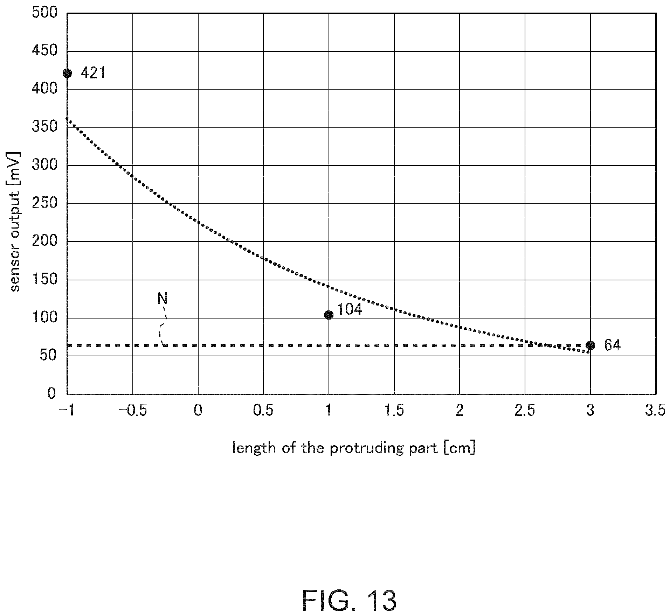

FIG. 13 is a graph illustrating the relationship between the length of the protruding part 311 of the table 310 and sensor output when no sample 320 is present. In this graph, the horizontal axis represents the X-direction length of the protruding part 311 from the element formation surface 41 of the magnetic sensor 40. The sensor output denoted by N is output level obtained when measurement is performed without inserting the sample stage 300, i.e., the level of background noise.

In the example illustrated in FIG. 13, sensor output obtained when the protruding part 311 has an X-direction length of 3 cm is 64 mV, which is substantially the same in level as the background noise. This indicates that the protruding part 311 of the table 310 is not electrostatically charged. On the other hand, sensor output obtained when the protruding part 311 has an X-direction length of 1 cm is 104 mV, which is slightly higher in level than the background noise. The reason for this is considered that the magnetic sensor 40 gathers noise caused by static electricity with which the sample stage 300 is charged due to decrease in distance between the magnetic sensor 40 and the sample stage 300 although the table 310 itself is not electrostatically charged.

Further, when the table 310 is not made to protrude from the mounting part 301 of the sample stage 300 but is disposed so as to entirely overlap the mounting part 301 of the sample stage 300, sensor output appearing at the position ("-1" in the graph of FIG. 13) 1 cm from the X-direction end portion of the mounting part 301 is 421 mV, which reveals that there is strong influence of noise caused by static electricity with which the sample stage 300 is charged. When these plots are subjected to curve approximation, the influence of static electricity is substantially eliminated provided that the X-direction length of the protruding part 311 is 2.7 cm or more.

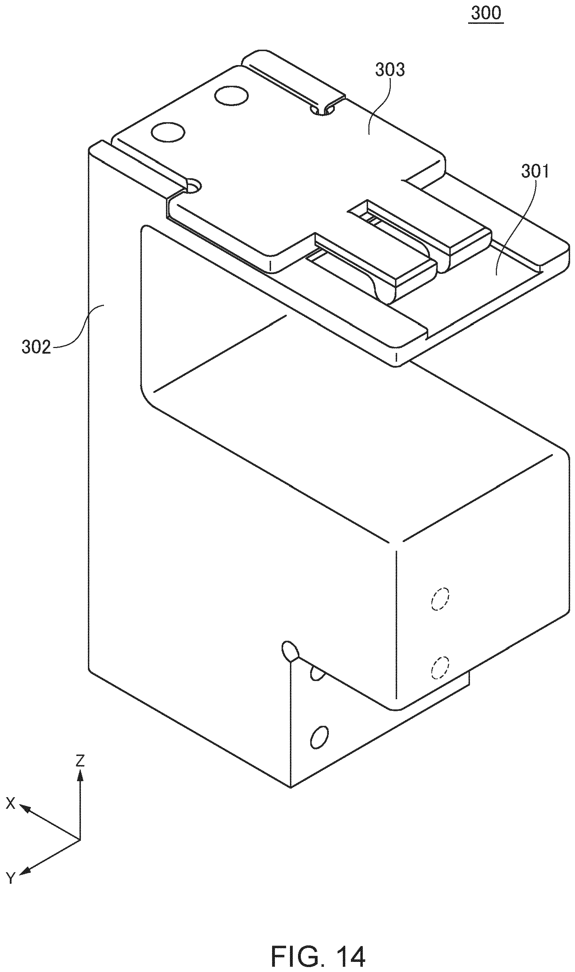

However, an increase in the X-direction length of the protruding part 311 makes stable placement of the table 310 on the mounting part 301 of the sample stage 300. Therefore, when the X-direction length of the protruding part 311 is large, as shown in FIG. 14, a movable holding part 303 is provided to the sample stage 300, and the table 310 is inserted between the mounting part 301 and the holding part 303, whereby the table 310 can be stably placed on the mounting part 301.

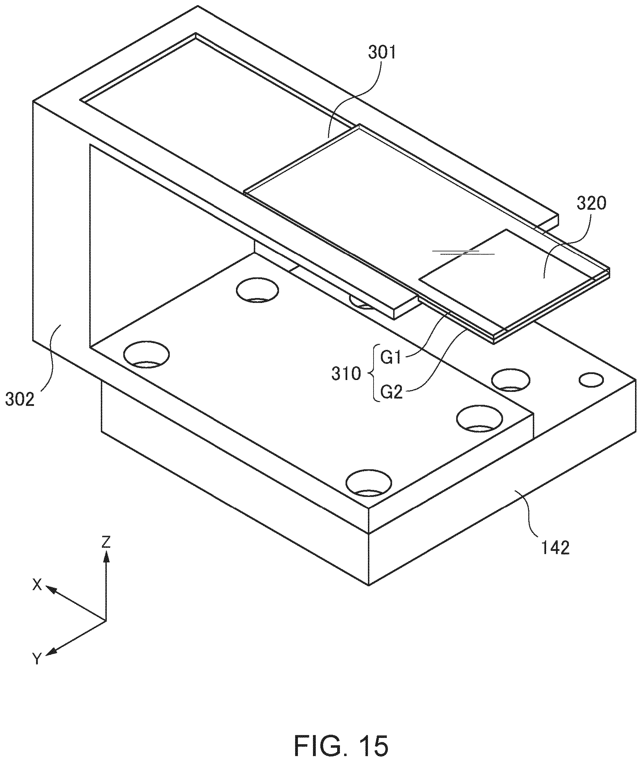

FIG. 15 is a schematic perspective view for explaining a first modification.

The first modification illustrated in FIG. 15 differs from the above embodiment in that the table 310 is composed of two transparent glass plates G1 and G2. The sample 320 is sandwiched between the glass plates G1 and G2 at the protruding part not overlapping the mounting part 301 of the sample stage 300. The sample 320 thus sandwiched between the two glass plates G1 and G2 is supported more stably and is also visually recognizable.

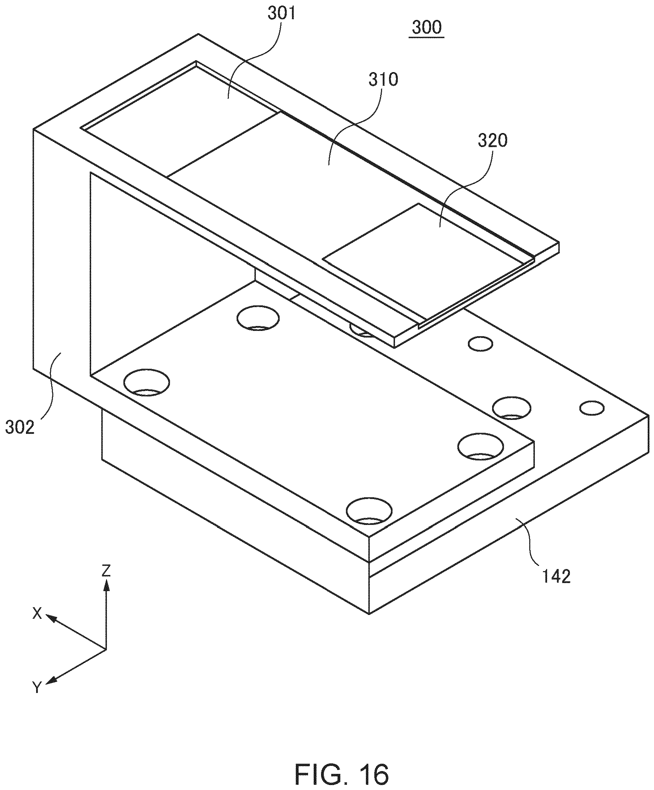

FIG. 16 is a schematic perspective view for explaining a second modification.

The second embodiment illustrated in FIG. 16 differs from the above embodiment in that the table 310 does not protrude from the mounting part 301 of the sample stage 300. In this case, when a material having a work function of 4 eV or less is used for both the sample stage 300 and table 310, it is possible to suppress deterioration in detection sensitivity due to static electricity. For example, glass may be used for both the sample stage 300 and table 310. Alternatively, wood and glass may be used respectively for the sample stage 300 and table 310.

Even in this case, both the sample stage 300 and table 310 are preferably constituted by a material positioned at the more positive side in the triboelectric series than aluminum, and the table 310 is preferably constituted by a material positioned at the more positive side in the triboelectric series than a material constituting the sample stage 300. Further, also in this example, the sample 320 may be sandwiched between the two transparent glass plates G1 and G2.

While some embodiments of the technology according to the present disclosure have been described, the technology according to the present disclosure is not limited to the above embodiments, and various modifications may be made within the scope of the present disclosure, and all such modifications are included in the technology according to the present disclosure.

The technology according to the present disclosure includes the following configuration examples, but not limited thereto.

A magnetic field detection system according to an embodiment of the present disclosure includes: a shield box having a magnetic shield surrounding a measurement space; a magnetic sensor provided in the measurement space and fixed to the shield box; a sample stage at least a part of which is inserted into the measurement space; a table fixed to the sample stage and on which a sample is placed; and a drive mechanism for changing the position of the sample stage, wherein the table has a protruding part protruding from the sample stage without overlapping the same, and at least the protruding part of the table is constituted by a material positioned at the more positive side in a triboelectric series than a material constituting the sample stage. Thus, at least the protruding part of the table is constituted by a material that is unlikely to be electrostatically charged, so that even when the sample stage is electrostatically charged by the movement of the sample stage, noise caused by static electricity can be reduced.

In the above magnetic field detection system, at least the protruding part of the table may be constituted by a material having a work function of 4 eV or less, may be constituted by a material positioned at the more positive side in the triboelectric series than aluminum, or may be constituted by glass. This makes at least the protruding part of the table less likely to be electrostatically charged. In this case, at least the protruding part of the table may be composed of two transparent glass plates, and the sample may be sandwiched between the two glass plates. Thus, the sample is supported more stably and is also visually recognizable.

A magnetic field detection system according to another embodiment of the present disclosure includes: a shield box having a magnetic shield surrounding a measurement space; a magnetic sensor provided in the measurement space and fixed to the shield box; a sample stage at least a part of which is inserted into the measurement space; a table fixed to the sample stage and on which a sample is placed; and a drive mechanism for changing the position of the sample stage, wherein both the sample stage and table are constituted by a material having a work function of 4 eV or less. This makes the sample stage and table unlikely to be electrostatically charged even when the sample stage is moved, making it possible to reduce noise due to static electricity.

In the above magnetic field detection system, both the sample stage and table may be constituted by a material positioned at the more positive side in the triboelectric series than aluminum. This makes the sample stage and table less likely to be electrostatically charged. Further, the table may be constituted by a material positioned at the more positive side in the triboelectric series than a material constituting the sample stage or may be constituted by glass. This makes the table less likely to be electrostatically charged. In this case, the table may be composed of two transparent glass plates, and the sample may be sandwiched between the two glass plates. Thus, the sample is supported more stably and is also visually recognizable.

## Claims

1. A magnetic field detection system comprising:
a shield box having a magnetic shield surrounding a measurement space;
a magnetic sensor provided in the measurement space and fixed to the shield box;
a sample stage at least a part of which is inserted into the measurement space;
a table fixed to the sample stage and on which a sample is placed; and
a drive mechanism configured to change a position of the sample stage,
wherein the table has a protruding part protruding from the sample stage without overlapping the sample stage, and
wherein at least the protruding part of the table is constituted by a material positioned at a more positive side in a triboelectric series than a material constituting the sample stage.

2. The magnetic field detection system as claimed in claim 1, wherein at least the protruding part of the table is constituted by a material having a work function of 4 eV or less.

3. The magnetic field detection system as claimed in claim 1, wherein at least the protruding part of the table is constituted by a material positioned at a more positive side in the triboelectric series than aluminum.

4. The magnetic field detection system as claimed in any one of claims 1 to 3, wherein at least the protruding part of the table is constituted by glass.

5. The magnetic field detection system as claimed in claim 4,
wherein at least the protruding part of the table includes two transparent glass plates, and
wherein the sample is sandwiched between the two glass plates.
